Europäisches Patentamt

European Patent Office

Office européen des brevets

(19)

(11) Veröffentlichungsnummer : **0 098 998**
**B1**

(12) **EUROPÄISCHE PATENTSCHRIFT**

(45) Veröffentlichungstag der Patentschrift :
15.03.89

(51) Int. Cl.⁴ : **H 01 L 31/10**

(21) Anmeldenummer : 83106053.8

(22) Anmeldetag : 21.06.83

(54) **Lichtzündbarer Thyristor mit geringem Lichtleistungsbedarf und hoher kritischer Spannungsanstiegsgeschwindigkeit.**

(30) Priorität : 16.07.82 DE 3226624

(43) Veröffentlichungstag der Anmeldung :
25.01.84 Patentblatt 84/04

(45) Bekanntmachung des Hinweises auf die Patenterteilung : 15.03.89 Patentblatt 89/11

(84) Benannte Vertragsstaaten :
**CH DE FR GB LI NL SE**

(56) Entgegenhaltungen :
**EP—A— 0 014 435**
**EP—A— 0 098 997**
**DE—A— 2 408 079**
**DE—A— 2 628 792**
**DE—A— 3 018 542**
**GB—A— 2 070 330**
**US—A— 4 207 584**

(73) Patentinhaber : **Siemens Aktiengesellschaft Berlin und München**
**Wittelsbacherplatz 2**
**D-8000 München 2 (DE)**

(72) Erfinder : **Herberg, Helmut, Dr.**
**Bruderhofstrasse 30a**
**D-8000 München 70 (DE)**

**Beschreibung**

Die Erfindung bezieht sich auf einen Thyristor nach dem Oberbegriff des Patentanspruchs 1.

Ein Thyristor dieser Art ist aus der DE-A-2904424 bekannt. Hierbei stellt ein Teil des n-Emitters, der dem an die Grenzfläche tretenden Ansatz der p-Basis benachbart ist, das Sourcegebiet eines mittels der Gateelektrode steuerbaren MIS-FET dar, dessen Draingebiet aus dem an die Grenzfläche tretenden Ansatz der n-Basis gebildet wird. Erhält die Gateelektrode eine Spannung zugeführt, die über der Einsatzspannung liegt, so fließt ein Strom aus dem Lastkreis des Thyristors über den MIS-FET in die n-Basis, wodurch die Zündung eingeleitet wird.

Der Erfindung liegt die Aufgabe zugrunde, einen Thyristor der eingangs genannten Art als lichtzündbaren Thyristor auszubilden, und zwar derart, daß er trotz einer hohen kritischen Spannungsanstiegsgeschwindigkeit dU/dt bezüglich einer anliegenden Blockierspannung U mit einer sehr geringen Lichtleistung gezündet werden kann. Gemäß der Erfindung wird dies durch die im kennzeichnenden Teil des Patentanspruchs 1 angeführten Merkmale erreicht.

Der mit der Erfindung erzielbare Vorteil besteht insbesondere darin, daß eine über den lichtempfindlichen Widerstand abgeleitete Teilspannung, die der Gateelektrode zugeführt wird, in einfacher Weise so eingestellt werden kann, daß sie im unbeleuchteten Zustand des Widerstandes nur wenig unterhalb der Einsatzspannung des MIS-FET liegt. Bei einer nur schwachen Beleuchtung des Widerstandes erfolgt dann bereits ein solcher Spannungsanstieg an der Gateelektrode, daß der MIS-FET leitend wird, wobei der Thyristor schnell und sicher zündet. Der Thyristor ist völlig unabhängig von der hierdurch gegebenen großen Zündempfindlichkeit so ausgebildet, daß er eine hohe Sperrfähigkeit und insbesondere eine große kritische Spannungsanstiegsgeschwindigkeit dU/dt hinsichtlich einer zwischen den anoden- und kathodenseitigen Elektroden anliegenden Blockierspannung U besitzt, was in herkömmlicher Weise, z. B. durch den Einbau von Emitter-Kurzschlüssen, erreicht wird.

Die Erfindung wird nachfolgend anhand der Zeichnung näher erläutert. Dabei zeigt :

Fig. 1 das Prinzipschaltbild eines Ausführungsbeispiels der Erfindung,

Fig. 2 den Verlauf der sich längs des pn-Übergangs zwischen der p-Basis und der n-Basis ausbildenden Raumladungszone bei einer kleinen Blockierspannung,

Fig. 3 den Verlauf dieser Raumladungszone bei einer grossen Blockierspannung und

Fig. 4 eine bevorzugte Ausgestaltung des Ausführungsbeispiels nach Fig. 1.

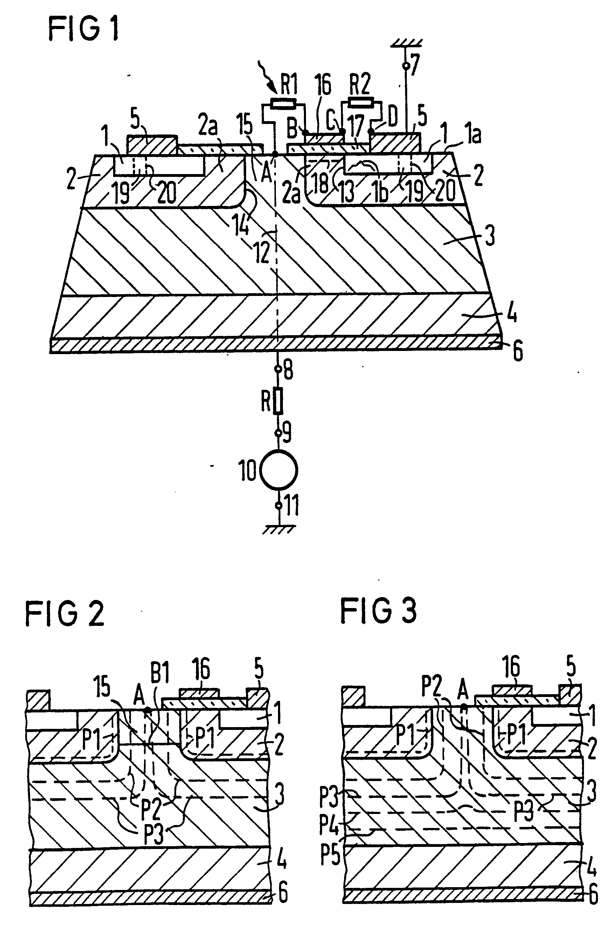

In Fig. 1 ist ein Thyristor mit einem Halbleiterkörper aus dotiertem Halbleitermaterial, z. B. Silizium, dargestellt, der vier aufeinanderfolgende Schichten abwechselnder Leitungstypen aufweist. Bei diesen handelt es sich um den n-Emitter 1, die p-Basis 2, die n-Basis 3 und den p-Emitter 4. Der n-Emitter 1 ist mit einer kathodenseitigen Elektrode 5 versehen, der p-Emitter 4 mit einer anodenseitigen Elektrode 6, wobei die Elektroden aus einem elektrisch leitenden Material, z. B. Aluminium, bestehen.

Die Elektrode 5 ist über einen Anschluß 7 mit Masse verbunden, die Elektrode 6 über einen Anschluß 8 und einen Lastwiderstand R mit dem oberen Anschluß 9 einer Spannungsquelle 10, deren unterer Anschluß 11 auf Masse liegt.

Die p-Basis 2 weist einen Ansatz 2a auf, der sich bis zu der kathodenseitigen Grenzfläche 1a des Halbleiterkörpers erstreckt. Bei einem rotationssymmetrischen Thyristoraufbau, der durch eine strichpunktierte Symmetrieachse 12 angedeutet ist, sind die Teile 1 und 5 ringförmig ausgebildet, wobei 13 eine zentrale Ausnehmung des n-Emitters 1 bezeichnet, die von einem zentrischen Ansatz 2a ausgefüllt wird. Besitzt der n-Emitter 1 dagegen eine Streifenstruktur, was so zu verstehen ist, daß die dargestellten Teile 1 und 5 jeweils streifenförmig ausgebildet sind und zum Beispiel senkrecht zur Bildebene von Figur 1 über die gesamte Grenzfläche 1a oder über wesentliche Teile derselben verlaufen, so stellt der Ansatz 2a einen ebenfalls streifenförmigen Steg dar, der die Teile 1 voneinander trennt. Dabei können die Teile 1 an ihren Enden derart miteinander verbunden sein, daß eine U-förmige Emitterstruktur entsteht. Die Teile 1 können auch so gestaltet sein, daß sie in der Grenzfläche 1a nach einer beliebigen Kurve (Spirale oder dergl.) verlaufen.

Der Ansatz 2a der p-Basis 2 hat eine Ausnehmung 14, die von einem Ansatz 15 der n-Basis 3 ausgefüllt wird, welcher sich bis zur Grenzfläche 1a erstreckt. Die Ausnehmung 14 und der Ansatz 15 können dabei entsprechend dem Ansatz 2a kreisförmig oder streifenförmig ausgebildet sein.

Mit 16 ist eine Gateelektrode bezeichnet, die den rechten Teil des an die Grenzfläche 1a tretenden Ansatzes 2a überdeckt und durch eine elektrisch isolierende Schicht 17 von der Grenzfläche 1a getrennt ist. Dabei bilden der Teilbereich 1b des n-Emitters 1 das Sourcegebiet, der rechte Teil des Ansatzes 2a das Kanalgebiet und der an diesen angrenzende Teil des Ansatzes 15 das Draingebiet eines n-Kanal-MIS-FET, d. h. eines Feldeffekttransistors mit einem Metall-Isolator-Halbleiter-Aufbau, der über die Gateelektrode 16 angesteuert wird. Legt man an die letztere eine hinreichend große positive Spannung an, so bildet sich unterhalb von 16 an der Grenzfläche 1a ein Inversionskanal 18 aus, der eine niederohmige Verbindung zwischen dem n-Emitter 1 und der n-Basis 3 darstellt. Unter dem Einfluß einer Blockierspannung, die den Anschluß 8 gegenüber dem Anschluß 7 positiv vorspannt, werden dann Elektronen aus dem n-Emitter 1 über den Kanal 18 in die n-Basis 3 transportiert, wodurch eine Emission von Defektelektronen aus dem pn-Übergang zwischen den Teilen 3 und 4 in Richtung auf den n-Emitter 1 und in weiterer Folge eine Emission von Elektronen aus dem pn-Übergang zwischen den Teilen 1 und 2 in Richtung auf den p-

2

Emitter 4 hervorgerufen werden. Diese sich gegenseitig verstärkenden Vorgänge bewirken eine schnelle und großflächige Zündung des Thyristors.

Fig. 2 zeigt den Verlauf der Raumladungszone, die sich in Fig. 1 bei einer kleinen Blockierspannung zwischen den Elektroden 5 und 6 an dem in Sperrichtung gepolten pn-Übergang zwischen der p-Basis 2 und der n-Basis 3 ergibt, während Fig. 3 den Verlauf dieser Raumladungszone bei einer großen Blockierspannung darstellt. Mit P1 bis P5 sind Äquipotentiallinien bezeichnet, die jeweils festen Potentialwerten entsprechen. Geht man in Fig. 2 davon aus, daß die Elektrode 5 auf Masse liegt und die Elektrode 6 mit einer Blockierspannung U1 beschaltet ist, so entspricht die Linie P1, die die Raumladungszone nach oben begrenzt, einem sehr kleinen Potentialwert, der sich nur wenig von Null unterscheidet, P2 einem mittleren Potentialwert und die Linie P3, die die Raumladungszone nach unten begrenzt, einem Potentialwert, der etwa dem Spannungswert U1 entspricht. Dabei weist auch ein Punkt A in der Grenzfläche 1a den Potentialwert P3 auf. U1 sei dabei so gewählt, daß sich die etwa senkrecht verlaufenden Abschnitte der Äquipotentiallinien P3 im Punkte A treffen. Bei einer Breite B1 des Ansatzes 15 von ca. 50 bis 200 µm liegt die Spannung U1, bei der eine Konfiguration der Raumladungszone nach Fig. 2 auftritt, je nach dem Dotierungsgrad der n-Basis 3 z. B. zwischen 20 und 200 Volt.

Wird nun die Spannung an der Elektrode 6 über U1 hinaus erhöht (Fig. 3), so vergrößert sich die Raumladungszone, was durch die hinzutretenden Äquipotentiallinien P4 und P5 angedeutet ist. P5 begrenzt dann die Raumladungszone nach unten und bezeichnet einen Potentialwert, der etwa der erhöhten Spannung an der Elektrode 6 entspricht. Wesentlich ist hierbei, daß jede Erhöhung der Spannung an der Elektrode 6 bis zum Wert U1 eine entsprechende Erhöhung des Potentials am Punkt A zur Folge hat, während jede Erhöhung über den Wert U1 hinaus das Potential im Punkt A praktisch nicht mehr verändert.

In Fig. 1 ist ein lichtempfindlicher Widerstand R1 dargestellt, der einerseits den Ansatz 15 der n-Basis 3 im Punkt A kontaktiert und andererseits mit der Gateelektrode 16 verbunden ist. Der Verbindungspunkt von R1 und 16 ist dabei zum besseren Verständnis des Schaltungsprinzips mit B bezeichnet und an das linke Ende der Gateelektrode 16 gelegt. Unter einem lichtempfindlichen Widerstand wird jeder Widerstand verstanden, der unter Lichteinwirkung seinen Widerstandswert verringert. Beispielsweise kann es sich um einen Fotowiderstand handeln, wie er in dem Buch von G. Hatzinger « Optoelektronische Bauelemente und Schaltungen » herausgegeben von der SIEMENS AG, Berlin, München, 1977, auf den Seiten 36 bis 41 beschrieben ist. Zwischen die Gateelektrode 16 und die kathodenseitige Elektrode 5 ist ein weiterer Widerstand R2 geschaltet, wobei die Verbindungspunkte C und D ebenfalls aus Gründen einer übersichtlichen Darstellung jeweils an das rechte Ende von 16 und an das linke Ende von 5 gelegt werden.

Hat der Widerstand R1 ohne Beleuchtung einen Widerstandswert $R_{AB}$ und der Widerstand R2 einen Widerstandswert $R_{CD}$, so ergibt sich bei einer am Punkt A anliegenden Spannung $U_A$ wegen der Spannungsteilung durch R1 und R2 an der Gateelektrode 16 eine Spannung $U_G$ nach folgender Beziehung :

$$U_G = \frac{R_{CD}}{R_{AB} + R_{CD}} \cdot U_A \qquad (1)$$

Die Widerstandswerte $R_{AB}$ und $R_{CD}$ werden so gewählt, daß $U_G$ kleiner ist als die Einsatzspannung des MIS-FET. Wird der lichtempfindliche Widerstand R1 beleuchtet, so verringert sich sein Widerstandswert von $R_{AB}$ auf $R_{AB}'$, wobei sich an 16 eine Spannung $U_G'$ folgender Größe ergibt :

$$U_G' = \frac{R_{CD}}{R_{AB}' + R_{CD}} \cdot U_A \qquad (2)$$

$U_G'$ liegt dabei über der Einsatzspannung des MIS-FET, so daß der Inversionskanal 18 gebildet wird, über den der Thyristor bei einer anliegenden Blockierspannung einen Zündstrom aus dem Lastkreis 7 bis 11 erhält, der ihn sehr schnell zündet. Zweckmäßigerweise werden $R_{AB}$ und $R_{CD}$ so gewählt, daß $U_G$ knapp unterhalb der Einsatzspannung liegt, so daß auch schon bei einer kleinen Widerstandsdifferenz $R_{AB} — R_{AB}'$ die Einsatzspannung durch den Spannungswert $U_G'$ sicher überschritten wird. Dies bedeutet aber, daß der Thyristor eine große Zündempfindlichkeit besitzt. Völlig unabhängig davon weist der Thyristor durch die Anwendung geeigneter, an sich bekannter Maßnahmen eine grosse Sperrfähigkeit gegenüber hohen Blockierspannungen U an den Anschlüssen 7, 8 auf. Diese Maßnahmen gewährleisten gleichzeitig eine hohe kritische Spannungsanstiegsgeschwindigkeit dU/dt, bis zu der eine unerwünschte Zündung des Thyristors sicher vermieden wird. Zu diesen Maßnahmen gehört beispielsweise das Anbringen von festen Emitter-Kurzschlüssen am n-Emitter 1. Diese bestehen aus Ansätzen 19 der p-Basis 2, die entsprechende Ausnehmung 20 des n-Emitters 1 ausfüllen und sich bis zur Grenzfläche 1a erstrecken, in der sie von der Elektrode 5 kontaktiert werden.

Bei einem Thyristor nach Fig. 1 sind nach obigem die beiden Parameter Zündempflindlichkeit und Sperrfähigkeit weitgehend unabhängig voneinander einstellbar, d. h. voneinander entkoppelt.

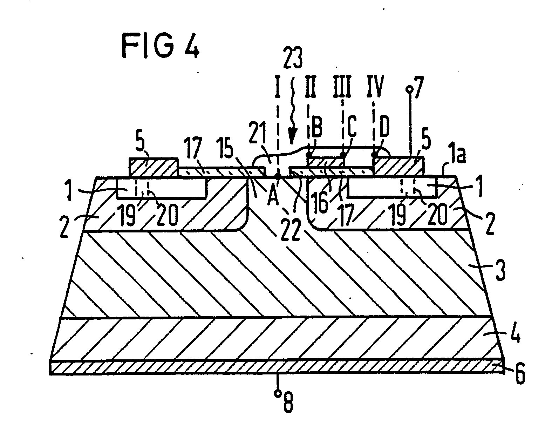

Fig. 4 zeigt eine Ausgestaltung des Thyristors nach Fig. 1, bei der die Widerstände R1 und R2 durch eine widerstandsbehaftete Schicht 21 mit einem belichtungsabhängigen Widerstand realisiert sind, die über der isolierenden Schicht 17 und der Gateelektrode 16 angebracht ist. Dabei füllt sie eine bis zur Grenzfläche 1a reichende Ausnehmung 22 der isolierenden Schicht 17 aus und kontaktiert den Ansatz 15 der p-Basis 3 im Bereich des Punktes A (Fig. 1). Die unbeleuchtete Schicht 21 weist zwischen den Punkten A und B den Widerstandswert $R_{AB}$ auf, zwischen den Punkten C und D den Widerstandswert $R_{CD}$. Der Widerstandswert $R_{AB}$ läßt sich in Fig. 4 etwa durch den gegenseitigen Abstand von durch die Punkte A und B gehenden Querschnittsebenen I und II veranschaulichen, der Widerstandswert $R_{CD}$ durch den gegenseitigen Abstand von Querschnittsebenen III und IV, die durch die Punkte C und D verlaufen. Der Widerstand der Schicht 21 zwischen den Ebenen II und III sowie rechts von der Ebene IV ist wegen der großen Leitfähigkeit der Elektroden 16 und 5 zu vernachlässigen.

Beleuchtet man den zwischen I und II liegenden Abschnitt durch einfallendes Licht 23, so verringert sich der zwischen A und B gemessene Widerstandswert der Schicht 21 von $R_{AB}$ auf $R_{AB'}$. Zweckmäßigerweise besteht die Schicht 21 aus amorphen Silizium. Ihr spezifischer Widerstandswert verringert sich dann bei Belichtung mit sichtbarem Licht von z. B. $10^7\ \Omega cm$ auf $10^3\ \Omega cm$. Andererseits kann die Schicht 21 auch aus einem Material bestehen, das für Fotowiderstände verwendet wird, wie z. B. Cadmiumsulfid oder Cadmiumselenid.

**Patentansprüche**

1. Thyristor mit einem Halbleiterkörper, der einen von einer kathodenseitigen Elektrode (5) kontaktierten n-Emitter (1) mit einer angrenzenden p-Basis (2) und einen von einer anodenseitigen Elektrode (6) kontaktierten p-Emitter (4) mit einer angrenzenden n-Basis (3) enthält, die ihrerseits an die p-Basis angrenzt, mit einem Ansatz (2a) der p-Basis, der sich bis zu einer Grenzfläche (1a) des Halbleiterkörpers erstreckt, mit einem diesem benachbarten, sich ebenfalls bis zu dieser Grenzfläche erstreckenden Ansatz (15) der n-Basis und mit einer auf dieser Grenzfläche angeordneten, gegen dieselbe isolierten Gateelektrode (16), die den Ansatz der p-Basis überdeckt, gekennzeichnet durch einen zum Zünden des Thyristors beleuchtbaren, lichtempfindlichen Widerstand (R1), der einerseits mit der Gateelektrode (16) verbunden ist und andererseits den Ansatz (15) der n-Basis (3) innerhalb einer sich am pn-Übergang zum Ansatz (2a) der p-Basis (2) im blockierenden Zustand des Thyristors aufbauenden Raumladungszone kontaktiert und durch einen weiteren Widerstand (R2), der zwischen die Gateelektrode (16) und die kathodenseitige Elektrode (5) geschaltet ist.

2. Thyristor nach Anspruch 1, gekennzeichnet durch eine auf der Gateelektrode (16) aufgebrachte, Schicht (21), die einen belichtungsabhängigen Schichtwiderstand aufweist, wobei sie sich einerseits bis zu dem Ansatz (15) der n-Basis (3) erstreckt und diesen kontaktiert, im übrigen jedoch gegenüber diesem Ansatz (15) isoliert angeordnet ist, und sich andererseits bis zu der kathodenseitigen Elektrode (5) erstreckt und mit dieser leitend verbunden ist, wobei der zwischen der Kontaktstelle (A) mit dem Ansatz (15) der n-Basis (3) und der Gateelektrode (16) liegende Abschnitt der Schicht den lichtempfindlichen Widerstand (R1) bildet und der zwischen der Gateelektrode (16) und der kathodenseitigen Elektrode (5) des Thyristors liegende Abschnitt der Schicht (21) den weiteren Widerstand (R2) darstellt.

3. Thyristor nach Anspruch 2, dadurch gekennzeichnet, daß die Schicht (21) aus amorphem Silizium besteht.

4. Thyristor nach Anspruch 2, dadurch gekennzeichnet, daß die Schicht (21) aus Cadmiumsulfid oder Cadmiumselenid besteht.

5. Thyristor nach einem der Ansprüche 1 bis 4, dadurch gekennzeichnet, daß der Ansatz (2a) der p-Basis (2), der sich bis zur Grenzfläche (1a) erstreckt, eine Ausnehmung (14) aufweist und daß der diesem Ansatz (2a) benachbarte Ansatz (15) der n-Basis (3) diese Ausnehmung (14) ausfüllt.

6. Thyristor nach einem der Ansprüche 1 bis 5, dadurch gekennzeichnet, daß einer der Emitter (1) mit Emitter-Kurzschlüssen (19, 20) versehen ist.

**Claims**

1. Thyristor comprising a semiconductor body which contains an n-type emitter (1), which is in contact with an electrode (5) on the cathode side, with an adjoining p-type base (2) and a p-type emitter (4), which is in contact with an electrode (6) on the anode side, with an adjoining n-type base (3) which, in turn, adjoins the p-type base with a projection (2a) of the p-type base which extends up to a boundary face (1a) of the semiconductor body, with a projection (15), thereto adjacent, of the n-type base which likewise extends up to this boundary face and with a gate electrode (16) which is arranged on this boundary face and which is insulated with respect to the latter and covers the projection of the p-type base, characterized by a light-sensitive resistance (R1) which can be illuminated for firing the thyristor and which, on the one hand, is connected to the gate electrode (16) and, on the other hand, is in contact with the projection (15) of the n-type base (3) within a space charge zone which builds up at the pn junction at the projection (2a) of the p-type base (2) in the blocking state of the thyristor, and by a further resistance (R2) which is connected between the gate electrode (16) and the electrode (5) on the cathode side.

2. Thyristor according to Claim 1, characterized by a layer (21) which is applied to the gate electrode (16) and which exhibits an illumination-dependent film resistance, this resistance extending, on the one hand, up to the projection (15) of the n-type base (3) and being in contact with the latter but, for the rest, being arranged insulated with respect to this projection (15) and, on the other hand, extending up to the electrode (5) on the cathode side and being conductively connected to the latter, the section, located between the contact point (A) to the projection (15) of the n-type base (3) and the gate electrode (16), of the layer forming the light-sensitive resistance (R1) and the section, located between the gate electrode (16) and the electrode (5) of the thyristor on the cathode side, of the layer (21) representing the further resistance (R2).

3. Thyristor according to Claim 2, characterized in that the layer (21) consists of amorphous silicon.

4. Thyristor according to Claim 2, characterized in that the layer (21) consists of cadmium sulphide or cadmium selenide.

5. Thyristor according to one of Claims 1 to 4, characterized in that the projection (2a) of the p-type base (2), which extends up to the boundary face (1a), exhibits a recess (14) and that the projection (15), adjacent to this projection (2a), of the n-type base (3) fills out this recess (14).

6. Thyristor according to one of Claims 1 to 5, characterized in that one of the emitters (1) is provided with emitter short circuits (19, 20).


## Revendications

1. Thyristor comportant un corps semiconducteur contenant un émetteur (1) de type n, placé en contact avec une électrode (5) située du côté cathode, et comportant une base contiguë (2) de type p, et un émetteur (4) de type p, placé en contact avec une électrode (6) située du côté anode, et comportant une base contiguë (3) de type n, qui jouxte pour sa part la base de type p, et comportant une partie saillante (2a) de la base p, qui s'étend jusqu'à l'interface (1a) du corps semiconducteur, et un appendice saillant (15) de la base de type n, qui est voisin de l'appendice saillant de la base de type p et s'étend également jusqu'au niveau de cette interface, et une électrode de grille (16) disposée sur cette interface en en étant isolée et recouvrant l'appendice saillant de la base de type p, caractérisé par une résistance photosensible (R1), qui peut être éclairée pour l'amorçage du thyristor et d'une part est reliée à l'électrode de grille (16) et d'autre part est en contact avec l'appendice saillant (15) de la base de type n (3) à l'intérieur d'une zone de charges d'espace qui s'établit au niveau de la jonction pn avec l'appendice saillant (2a) de la base de type p (2), lorsque le thyristor est à l'état bloqué, et par une autre résistance (R2) qui est branchée entre l'électrode de grille (16) et l'électrode (5) située du côté cathode.

2. Thyristor suivant la revendication 1, caractérisé par une couche (21) qui est déposée sur l'électrode de grille (16) et possède une résistance de couche dépendant de l'éclairement, et dans lequel d'une part cette couche s'étend jusqu'à l'appendice saillant (15) de la base de type n (3) et est en contact avec cette dernière, mais par ailleurs est isolée par rapport à cet appendice saillant (15), et d'autre part s'étend jusqu'à l'électrode (5) située du côté cathode et est reliée de façon conductrice à cette dernière, et dans lequel la section de la couche, qui est située entre le point de contact (A) avec l'appendice saillant (15) de la base de type n (3) et l'électrode de grille (16), forme la résistance photosensible (R1), et la section de la couche (21), située entre l'électrode de grille (7) et l'électrode (5) du thyristor, située côté cathode, représente l'autre résistance (R2).

3. Thyristor suivant la revendication 2, caractérisé par le fait que la couche (21) est constituée par du silicium amorphe.

4. Thyristor suivant la revendication 2, caractérisé par le fait que la couche (21) est constituée par du sulfure de cadmium ou du séléniure de cadmium.

5. Thyristor suivant l'une des revendications 1 à 4, caractérisé par le fait que l'appendice saillant (2a) de la base de type p (2), qui s'étend jusqu'au niveau de l'interface (26), possède un évidement (14) et que l'appendice saillant (15) de la base de type n (3), qui est voisin de cet appendice saillant (2a), remplit cet évidement (14).

6. Thyristor suivant l'une des revendications 1 à 5, caractérisé par le fait que l'un des émetteurs (1) est pourvu de courts-circuits d'émetteur (19, 20).

FIG 1

FIG 2

FIG 3

## FIG 4